# EUROPEAN PATENT APPLICATION

(11) **EP 1 353 187 A2**
(43) Date of publication of application: **15.10.2003**
(21) Application number: 03100868.3
(22) Date of filing: 02.04.2003
(51) Int. Cl.: G01R 31/26

(54) **Measuring junction leakage**

(30) Priority: 10.04.2002 GB 2084481
(71) Applicant: Zarlink Semiconductor Limited, Swindon, Wiltshire SN4 2QW (GB)
(72) Inventor: BEECH, Clive, David, Plymouth, Devon (GB)
(74) Representative: Robinson, John Stuart

(57) **Abstract**

A test structure (10) is provided for allowing a parametric test system, for example towards the end of a production line at a foundry, to measure the junction leakage of a semiconductor device such as an integrated circuit. The structure is formed as part of the device and comprises a MOSFET (3) whose source and drain are provided with connections (5 and 7) which are accessible to the tester for biasing the device and measuring the drain current. A capacitor (1) is connected between the gate of the MOSFET (3) and another connection (4) allowing the tester to supply various voltages to the connection (4). A junction diode (2) is connected between the gate of the MOSFET (3) and the body terminal and connection (6). During testing, the parametric tester supplies a voltage to the connection (4) to allow the capacitor 1 to be charged via the forward-biased diode (2). The connection (4) is then connected to another voltage such that the diode (2) becomes reverse-biased and its leakage current discharges the capacitor (1) so that the voltage on the gate of the MOSFET (3) falls. The drain current thus falls and the junction leakage through the diode (2) can be determined from the rate of change of the drain current and knowledge of the transfer characteristic of the MOSFET (3) and the capacitance of the capacitor (1).

## Description

The present invention relates to a test structure for permitting measurement of junction leakage of a semiconductor device and to such a device which includes such a test structure. The present invention also relates to a method of measuring junction leakage of such a device.

The quality of a semiconductor junction between n-type and p-type silicon (or other semiconductor material) may be characterised by the level of current which the junction passes when it is subjected to a reverse bias voltage. Such leakage current is generally referred to as "junction leakage". Each junction of a semiconductor, such as an integrated circuit, has a component of junction leakage associated with its area and one or more components associated with its periphery.

During the manufacture of semiconductor devices, it is important that the level of junction leakage is controlled. This level may be inferred from the performance of the device in the case of devices, such as imaging devices, where correct operation is highly dependent on the level of junction leakage.

It is common nowadays for semiconductor devices such as integrated circuits to be made by manufacturers who operate as a "foundry". In this case, the product of such a foundry is a processed silicon wafer and this is tested only for parametric conformance in such a foundry. In particular, the circuit performance is not evaluated. The foundry sells the wafer to a customer who then tests the functionality and performance of the circuit. It is undesirable for the foundry and the customer if the customer discovers junction leakage problems when the circuit is tested. Accordingly, it is very desirable for the junction leakage to be tested and any problems identified before the wafer leaves the foundry.

The parametric performance of the wafer is determined in the foundry by testing a set of elementary components which are usually located in the regions between adjacent devices on a wafer. This region is generally referred to as the "scribe lane" and is about 100 µm wide to permit the safe passage of a saw blade during separation of the wafer into individual devices. It is also known for these elementary components or test structures to be located within the device area of the wafer but this has the disadvantage that the area occupied by test structures is not then available for the device itself. Thus, in either case, it is necessary or desirable for such structures to occupy a minimum area of the wafer.

Towards the end of the foundry production line, the parametric tests are performed by a dedicated parametric test system, for example comprising programmable power supplies, voltmeters, ammeters, inductance/capacitance bridges and a switching matrix. The switching matrix connects the subsystems of the test system as appropriate to a set of probe needles which provide electrical connection to one or more elementary components forming the test structure on the surface of the silicon wafer. The elementary components may, for example, be a single metal oxide semiconductor field effect transistor (MOSFET), a resistor made of process material, a capacitor or some other component. The test system performs a range of tests in sequence on a range of elementary components in order to assess the integrated circuit performance and the conformance of the processed wafer. When the performance has been assessed, the processed wafer is accepted for finishing and supply to a customer or rejected.

It has proved to be difficult, impossible, or inconvenient to measure junction leakage when performing the parametric tests described hereinbefore towards the end of a production line. In particular, the parametric testers have a relatively high intrinsic leakage current level such that a practical system of this type is not capable of measuring sufficiently small currents, for example of the order of 10⁻¹⁰A, which give an indication of the level of junction leakage in the relatively small test structures which are acceptable on semiconductor wafers. Although junction diode test structures could, at least in theory, be provided with sufficiently large areas to make the current levels measurable by such parametric testers, the probability of a defect within such larger junctions would be substantially increased. When it is required to determine the individual components of junction leakage, for example resulting from area and periphery, several junction diodes having a range of areas and edge sizes and types are used and the results form a set of simultaneous equations which may be solved using conventional techniques. The presence of a defect in any of the junctions adds a non-systematic component to the leakage current and thus prevents a solution from being found.

According to a first aspect of the invention, there is provided a test structure for permitting measurement of junction leakage of a semiconductor device, comprising a first metal oxide semiconductor field effect transistor whose drain is accessible to permit the drain current to be measured, a junction diode having a first terminal connected to the gate of the transistor, and a first capacitor having a first terminal connected to the gate of the first transistor and a second terminal which is accessible to permit the voltage thereon to be selected.

The device may be an integrated circuit.

The second terminal of the diode may be accessible.

The second terminal of the diode may be connected to a body terminal of the first transistor.

The structure may comprise a second metal oxide semiconductor field effect transistor substantially identical to the first transistor and a second capacitor substantially identical to the first capacitor, the second transistor being accessible to permit the transfer characteristic thereof to be determined and the second capacitor being accessible to permit the capacitance thereof to be determined.

According to a second aspect of the invention, there is provided a semiconductor device comprising a test structure according to the first aspect of the invention.

The device may comprise an integrated circuit wafer having a scribe lane in which the test structure is formed.

According to a third aspect of the invention, there is provided a method of measuring junction leakage of a semiconductor device according to the second aspect of the invention, comprising connecting the second terminal of the first capacitor to a first voltage for forward-biasing the diode so as to charge the capacitor, connecting the second terminal of the first capacitor to a second voltage such that the diode is reverse-biased, and determining the junction leakage from the rate of change of the drain current.

The method may comprise determining the rate of change of the gate voltage of the first transistor from the rate of change of the drain current and the transfer characteristic of the first transistor. The method may comprise determining the transfer characteristic of the second transistor and using this as the transfer characteristic of the first transistor.

The method may comprise determining the junction leakage as the product of the rate of change of the gate voltage and the capacitance of the first capacitor. The method may comprise determining the capacitance of the second capacitor and using this as the capacitance of the first capacitor.

The method may comprise determining the junction leakage for a predetermined voltage across the diode.

According to a fourth aspect of the invention, there is provided a method of making a semiconductor device according to the second aspect of the invention, including testing the device by a method according to the third aspect of the invention.

According to a fifth aspect of the invention, there is provided a device made by a method according to the fourth aspect of the invention.

It is thus possible to provide a technique which allows junction leakage to be determined towards the end of a production line in a foundry. The effect of the junction leakage is effectively amplified by the first transistor to a level where a parametric tester can determine the junction leakage and assess the device for acceptability. The test structure requires a very small wafer area and can be incorporated in the scribe lane of a semiconductor wafer. Alternatively, the test structure is small enough to be located within the active area of the device without significantly reducing the area available for the device itself.

This technique reduces the probability of a faulty device suffering from unacceptable levels of junction leakage being supplied to a customer and so effectively increases the reliability of shipments from manufacturers such as foundries to their customers. The presence of the junction leakage testing has a substantially insignificant impact on the cost and convenience to the manufacturer. Existing equipment can be modified easily to perform the junction leakage testing, which takes typically all of the order of 10 seconds to perform.

The invention will be further described, by way of example, with reference to the accompanying drawings, in which:
Figure 1 is a circuit diagram of a test structure constituting an embodiment of the invention;
Figure 2 is a graph of capacitor voltage against time during testing using the structure of Figure 1;
Figure 3 is a graph of drain current against time during testing using the structure of Figure 1;
Figure 4 is a graph of drain current against gate voltage illustrating a typical transfer characteristic of the transistor of Figure 1;
Figure 5 is an example of a test routine for determining junction leakage constituting an embodiment of the invention; and
Figure 6 is a diagrammatic plan view of an integrated circuit wafer including a test structure as shown in Figure 1 and constituting an embodiment of the invention.

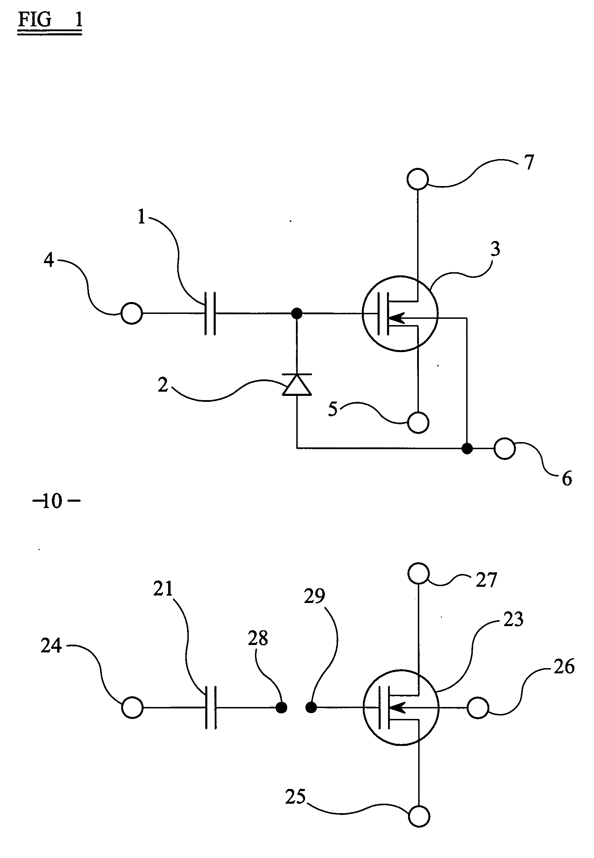

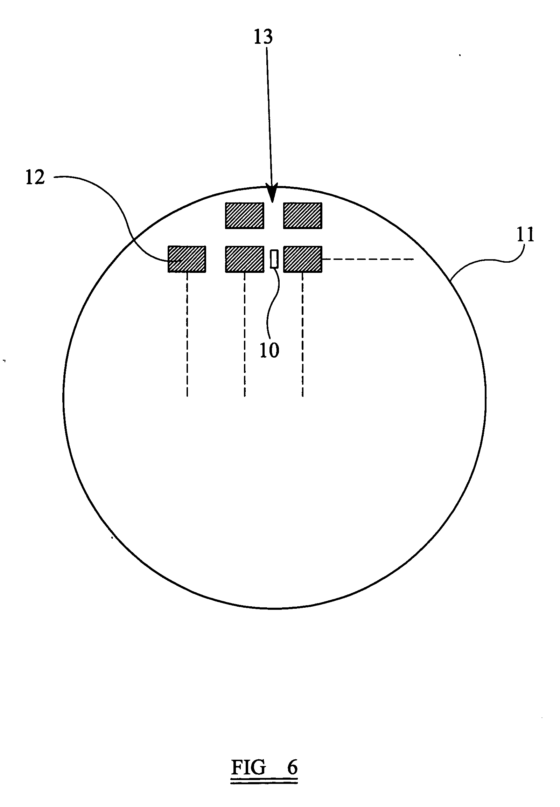

The test structure 10 illustrated in Figure 1 is intended for inclusion in a semiconductor wafer 11, containing integrated circuits such as 12 having scribe lanes such as 13 as shown in Figure 6. The structure 10 is located in the scribe lane 13 and allows evaluation of the junction leakage of junctions on the wafer 11 towards the end of manufacture, for example in a foundry. The structure 10 comprises a capacitor 1 of very low leakage having a first terminal connected to the cathode of a junction diode 2 and the gate of a metal oxide semiconductor field effect transistor (MOSFET) 3. The second terminal of the capacitor 1 is connected to a connection 4 which is accessible to a parametric tester for supplying a test voltage signal to the structure.

The MOSFET 3 is shown as being of NMOS type but may alternatively be of PMOS type. The MOSFET 3 has source and drain electrodes connected to connections 5 and 7 which are accessible, for example by being located on top of the wafer, to the parametric tester. In practice, the connection 5 is connected to ground whereas the connection 7 allows a supply voltage to be applied to the drain (relative to the source) and allows the drain current to be measured. The MOSFET 3 has a body connection connected to the anode of the diode 2 and to a further connection 6 which is accessible to the parametric tester.

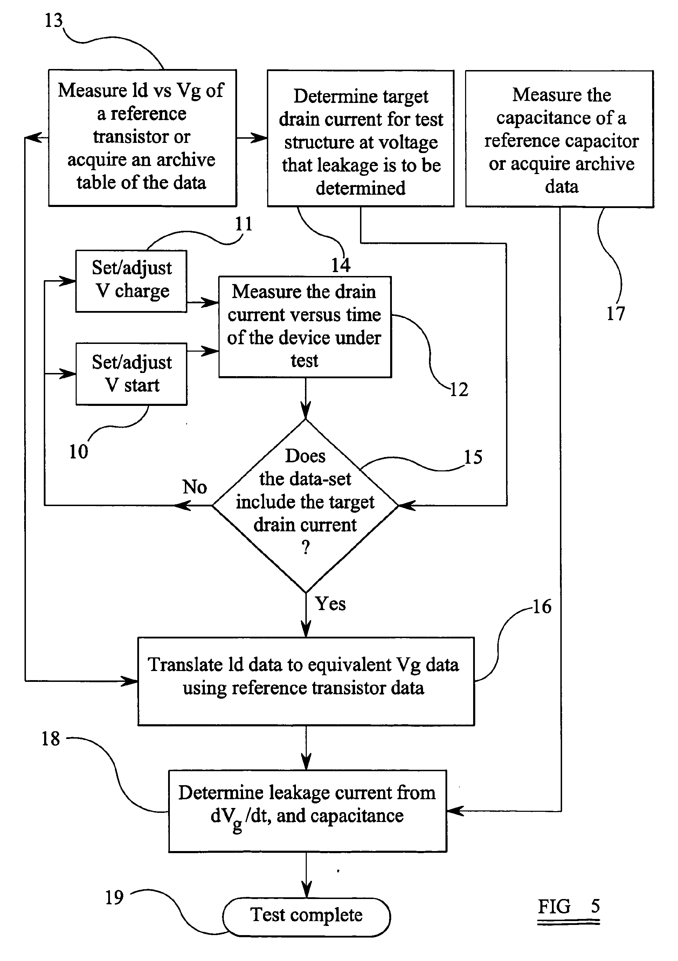

In practice, several test structures of the type shown in Figure 1 may be formed for each device with the diodes 2 of the structures having different areas and/or perimeter shapes and/or sizes. Also, one or more reference structures may be provided and one such reference structure is show in Figure 1 comprising a capacitor 21 and a transistor 23 of the same type as the capacitor 1 and the transistor 3, respectively. These structures have sufficient access, in the form of connections 24 to 29, to a parametric tester to allow the transfer characteristic of the or each reference transistor 23 to be determined and likewise the capacitance of the or each capacitor 21 of the reference structure. These parameters may vary, for nominally identical components, from place to place on a wafer, from wafer to wafer, or from process lot to process lot. The presence of one or more reference structures allows measurement of the parameters which, in turn, are used to determine the capacitance of the capacitor 1 and the transfer characteristic of the MOSFET 3 of the or each test structure. Alternatively, the characteristics of the components of the test structures may be derived from reference data, for example in the form of look-up tables and electrical simulation models.
In order to test the junction leakage of the device, a parametric tester is applied such that its probe needles contact the connections 4 to 7 with the connections 5 and 6 being connected to ground. The connection 7 is supplied with a bias voltage, for instance, of the order of +2 volts with respect to ground, and the current flowing through the drain-source path of the MOSFET 3 is measured. The succeeding steps are illustrated in the flow diagram of Figure 5.

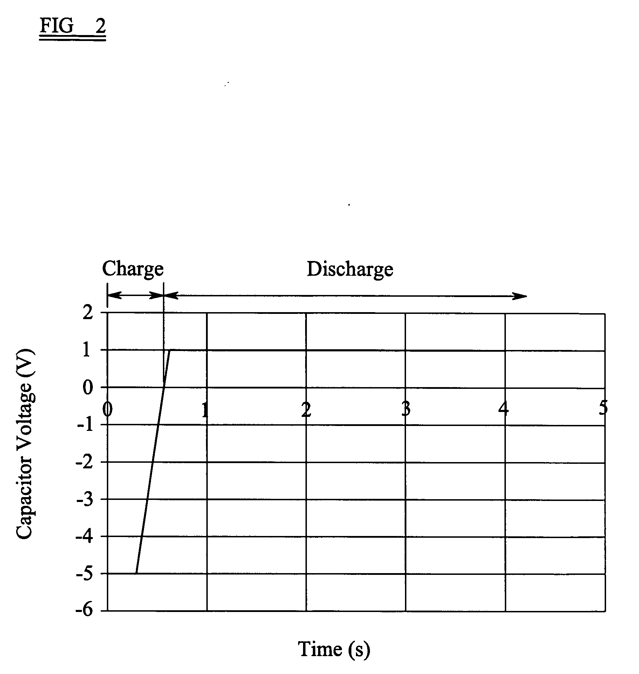

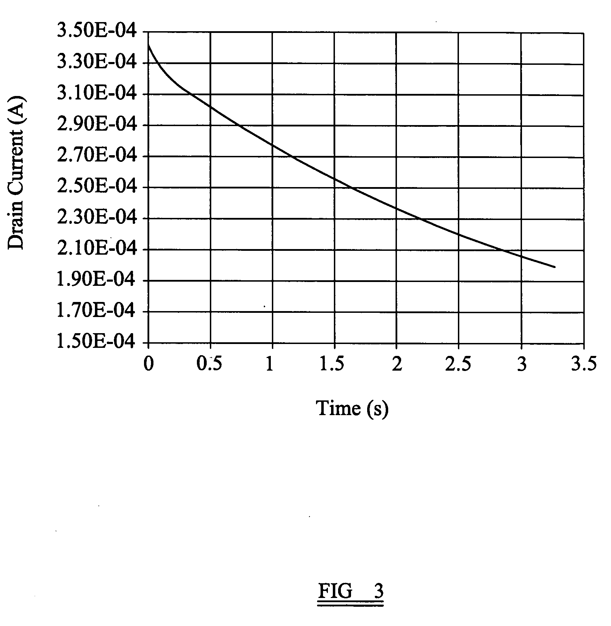

At 10 and 11, the voltage Vₛₜₐᵣₜ for the start of the test and the voltage V_{charge} for the next part of the test are set in the first iteration and adjusted in any following iterations. As illustrated in Figure 2, the terminal 4 receives a voltage Vₛₜₐᵣₜ of -5 volts relative to ground such that the diode 2 is forward-biased and the capacitor 1 is charged to a predetermined voltage which approaches a magnitude of 5 volts minus the forward voltage drop of the diode 2. After a period of approximately half a second, the parametric tester applies a voltage of +1 volt relative to ground to the connection 4. The voltage applied to the gate of the MOSFET 3 and to the cathode of the diode 2 becomes positive relative to ground and is of sufficient magnitude for the MOSFET 3 to turn on and cause a current to flow through the drain-source path. The diode 2 is reverse-biased and the junction leakage current, which is substantially greater than any other leakage currents, slowly discharges the capacitor 1 so that the voltage on the gate of the MOSFET, and hence the drain current, fall. The result of this is illustrated in Figure 3, which shows the steadily decreasing drain current after the diode 2 has become reverse-biased. This step is illustrated at 12 in Figure 5.

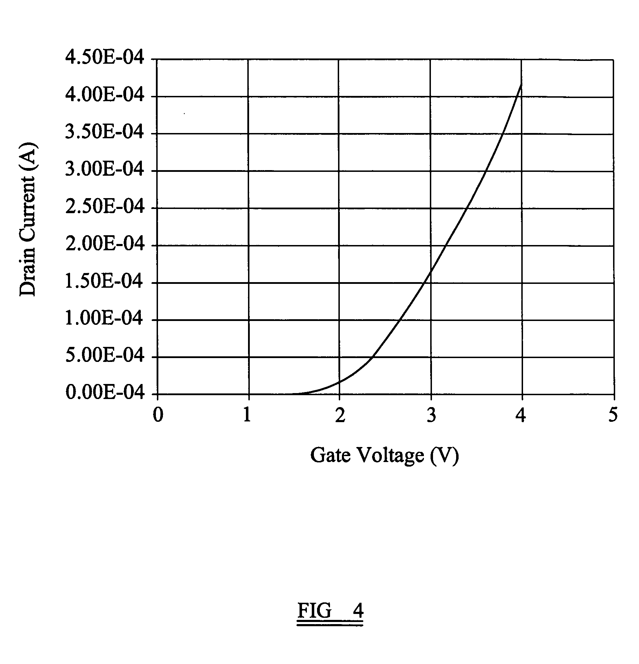

A step 13 in Figure 5 measures the drain current versus gate voltage of one of the reference transistors 23, or acquires this data from a look-up table, and determines the transfer characteristic as illustrated in Figure 4 for the reference transistor 23. Because the reference transistor 23 is on the same wafer 11 and preferably adjacent the test structure shown in Figure 1, and because the relative sizes of the reference transistor 23 and the transistor 3 are known (for example, they may be substantially identical) the transfer characteristic of the MOSFET 3 can be determined.

A step 14 determines a target drain current for the test structure at the voltage at which the leakage is required to be determined and supplies this to a step 15. The step 15 determines whether the target drain current has been achieved. If not, the steps 10 and 11 vary the voltages Vₛₜₐᵣₜ and V_{charge} and the step 12 is repeated until measurements are made at the target drain current.

A step 16 makes use of the transfer function determined in the step 13 and translates the drain current data to equivalent gate voltage data so that the rate of change of gate voltage with time can be determined in the step 16. A step 17 measures the capacitance of the reference capacitor 21 or acquires the appropriate data from a look-up table so that the capacitance of the capacitor 1 of the test structure is known or can be determined. A step 18 forms the product of the rate of change of gate voltage and the capacitance to determine the actual junction leakage current at the desired test voltage to give the desired measure of junction leakage and the test finishes at 19.

The test is performed on the exposed surface of the silicon wafer 11 because the connections 4 to 7 and 24 to 29 have to be accessible to the parametric tester. Because the junction diode 2 is sensitive to light, it is necessary to prevent any light from falling on the diode 2 during the test procedure.

This technique may be applied to any semiconductor device made of silicon or any other material. It is particularly useful for integrated circuit devices, for example where available wafer area is limited and that used for test structures should be reduced as much as possible. Also, the technique may be used with a range of diode styles, for example N+/P-well, P+/N- well, and N-well/P-well. The technique allows low levels of junction leakage to be determined using conventional parametric test systems. The test structure is compatible with space restrictions on a production semiconductor wafer 11.

## Claims

1. A test structure for permitting measurement of junction leakage of a semiconductor device (12), **characterised by** comprising a first metal oxide semiconductor field effect transistor (3) whose drain is accessible to permit the drain current to be measured, a junction diode (2) having a first terminal connected to the gate of the transistor (3), and a first capacitor (1) having a first terminal connected to the gate of the first transistor (3) and a second terminal which is accessible to permit the voltage thereon to be selected.

2. A test structure as claimed in claim 1, **characterised in that** the device is an integrated circuit (12).

3. A test structure as claimed in claim 1 or 2, **characterised in that** the second terminal of the diode (2) is accessible.

4. A test structure as claimed in any one of the preceding claims, **characterised in that** the second terminal of the diode (2) is connected to a body terminal of the first transistor (3).

5. A test structure as claimed in any one of the preceding claim, **characterised by** comprising a second metal oxide semiconductor field effect transistor (23) substantially identical to the first transistor (3) and a second capacitor (21) substantially identical to the first capacitor (1), the second transistor (23) being accessible to permit the transfer characteristic thereof to be determined and the second capacitor (21) being accessible to permit the capacitance thereof to be determined.

6. A semiconductor device **characterised by** comprising a test structure (10) as claimed in any one of the preceding claims.

7. A device as claimed in claim 6, comprising an integrated circuit wafer (11) having a scribe lane (13) in which the test structure (10) is formed.

8. A method of measuring junction leakage of a semiconductor device as claimed in claim 6 or 7, **characterised by** comprising connecting the second terminal of the first capacitor (1) to a first voltage for forward-biasing the diode (2) so as to charge the first capacitor (1), connecting the second terminal of the first capacitor (1) to a second voltage such that the diode (2) is reverse-biased, and determining the junction leakage from the rate of change of the drain current.

9. A method as claimed in claim 8, **characterised by** comprising determining the rate of change of the gate voltage of the first transistor (3) from the rate of change of the drain current and the transfer characteristic of the first transistor (3).

10. A method as claimed in claim 9 when dependent on claim 5, **characterised by** comprising determining the transfer characteristic of the second transistor (23) and using this as the transfer characteristic of the first transistor (3).

11. A method as claimed in claim 9 or 10, **characterised by** comprising determining the junction leakage as the product of the rate of change of the gate voltage and the capacitance of the first capacitor (1).

12. A method as claimed in claim 11 when dependent on claim 5, **characterised by** comprising determining the capacitance of the second capacitor (21) and using this as the capacitance of the first capacitor (1).

13. A method as claimed in any one of claims 8 to 12, **characterised by** comprising determining the junction leakage for a predetermined voltage across the diode (2).

14. A method of making a semiconductor device as claimed in claim 6 or 7, including testing the device by a method as claimed in any one of claims 8 to 13.

15. A device made by a method as claimed in claim 14.
